# EUROPEAN PATENT APPLICATION

(11) **EP 4 660 270 A1**
(43) Date of publication of application: **10.12.2025**
(21) Application number: 25160979.8
(22) Date of filing: 28.02.2025
(51) Int. Cl.: C09J 7/10

(54) **COMPOSITE ADHESIVE FILM, METHOD FOR PREPARING SAME, AND PHOTOVOLTAIC MODULE**

(30) Priority: 05.06.2024 CN 202410722442
(71) Applicant: Tongwei Solar (Chengdu) Co., Ltd., Chengdu, Sichuan 610299 (CN)
(72) Inventor: YU, Mingmao, Chengdu, 610299 (CN); SHEN, Haiping, Chengdu, 610299 (CN); XIA, Zhengyue, Chengdu, 610299 (CN); XING, Guoqiang, Chengdu, 610299 (CN)
(74) Representative: Marks & Clerk LLP

(57) **Abstract**

A composite adhesive film, a method for preparing the same, and a photovoltaic module are provided. The composite adhesive film includes an adhesive film layer and nanospheres. The nanospheres are distributed on the adhesive film layer, each of the nanospheres includes a polymer shell with pH acid responsiveness and an acid scavenger encapsulated within the polymer shell. The composite adhesive film can adjust a content of acetic acid in the photovoltaic module in time based on a stimulation-release principle of pH acid responsiveness, so that the photovoltaic module can be protected from acetic acid for a long time, and a component efficiency and a component reliability of the photovoltaic module can be improved.

## Description

### TECHNICAL FIELD

The present application relates to the field of photovoltaic module, in particular, to a composite adhesive film, a method for preparing the same, and a photovoltaic module.

### BACKGROUND

EVA (polyethylene-polyvinyl acetate copolymer) film, as one of the important components of a photovoltaic module, is mainly used to encapsulate and isolate solar panels as well as to fix a front panel of a cell and a back panel of a cell. EVA will gradually decompose and generate acetic acid as a by-product when exposed to strong ultraviolet (UV), high temperature (T) and high humidity (H). Once the acetic acid migrates to the surface of the cell, grid lines will be corroded, leading to a significant increase in the contact resistance of the battery, and even the phenomenon of grid breakage.

Currently, the solutions to the problem that the EVA decomposes and generate the by-product of acetic acid includes following solutions. (1) Adding an acid scavenger directly into the film containing EVA to neutralize the acetic acid generated by EVA decomposition, thus improving the reliability of components. However, too much acid scavenger will have a greater impact on crosslinking of adhesive film body, and a peel strength of the adhesive film also has a risk of decreasing; and too little acid remover cannot effectively achieve the function of acid removal for a long time. (2) Adhesive films such as EPE (a coextruded material of EVA and POE) adhesive film, POE (polyolefin elastomer) adhesive film, and the like are used instead of the EVA adhesive film. However, bonding performances of materials such as EPE and POE are far worse than the EVA. When the EPE adhesive film and the POE adhesive film are exposed in the outdoors for a long time exposure, problems such as the component encapsulation material cracking, delamination may occur. In addition, adhesive films such as the EPE adhesive film, the POE adhesive are more expensive, which may further increase the cost of component manufacturing and reduce competitive advantage. At the same time, the EPE adhesive film also contains the EVA, may generate acetic acid after being used in outdoors for a long time, and cannot completely solve the problem of acetic acid erosion.

### SUMMARY

In view of the above, it is necessary to provide a composite adhesive film. The adhesive composite in the present application is controllable in price and environmentally friendly, has a good adhesive performance, and can spontaneously remove acid for a long time. A component efficiency of the photovoltaic module and a component reliability of the photovoltaic module can be improved when the composite adhesive film in the present application is used in a photovoltaic module.

In an embodiment of the present application, a composite adhesive film is provided.

A composite adhesive film includes an adhesive film layer and nanospheres. The nanospheres are distributed on the adhesive film layer, each of the nanospheres includes a polymer shell with pH acid responsiveness and an acid scavenger encapsulated within the polymer shell.

In some embodiments, the adhesive film layer includes an EVA adhesive film or an EPE adhesive film.

In some embodiments, a particle size of the nanospheres is in a range of 50nm to 1000nm.

In some embodiments, a mass ratio of the adhesive film layer to the nanospheres is in a range of 20:1 to 150:1.

In some embodiments, a mass ratio of the polymer shell to the acid scavenger is in a range of 1:2 to 2:1.

In some embodiments, a material of the polymer shell is selected from the group consisting of polyacrylic acid polymers, polyacid polymers, polyalkali polymers, and any combination thereof.

In some embodiments, the acid scavenger is selected from the group consisting of zinc oxide, lead oxide, magnesium oxide, calcium carbonate, sodium carbonate, sodium bicarbonate, and any combination thereof.

In an embodiment of the present application, a method for preparing the composite adhesive film is further provided.

A method for preparing the composite adhesive film includes following steps:
mixing the nanospheres and a material of the adhesive film layer uniformly to obtain an adhesive film material,
extruding and casting the adhesive film material via a die to form the adhesive film layer and the nanospheres distributed on the adhesive film layer, and
obtaining the composite adhesive film by the adhesive film layer together with the nanospheres.

In some embodiments, the method for preparing the nanospheres further includes following steps:
dissolving a material of the polymer shell, a surfactant, an emulgator and the acid scavenger in a solvent to form an evenly-dissolved emulsion, wherein the emulsion includes, by mass fractio 10% to 30% of the material of the polymer shell, 30% to 40% of the solvent, 1% to 5% of the surfactant, 3% to 10% of the emulgator and 10% to 30% of the acid scavenger;
forming the emulsion into microsphere particles; and
sieving the microsphere particles and collecting the nanospheres.

In some embodiments, the method satisfies with at least one of the following conditions:
(1) in the step of preparing the emulsion into microsphere particles, further including: forming the emulsion into the microsphere particles by a spray drying method;
(2) in the step of sieving the microsphere particles and collecting the nanospheres, further including: collecting the nanospheres by means of dialysis bag sieving and collecting the nanospheres; and
(3) a temperature of the step of dissolving the material of the polymer shell, a surfactant, an emulgator and the acid scavenger in a solvent is in a range of 18 °C to 35 °C.

In some embodiments, the method satisfies with at least one of the following conditions:
(1) the material of the polymer shell includes a main shell component and a shell adjuvant; wherein the main shell component is selected from the group consisting of polyacrylic acid polymers, polyacid polymers, polyalkali polymers, and any combination thereof, the shell adjuvant is selected from the group consisting of calcium stearate, magnesium stearate, zinc stearate, and any combination thereof, and a mass ratio of the main shell component to the shell adjuvant is in a range of 1:4 to 4:1;
(2) the solvent is an incombustible solvent having a low boiling point;
(3) the surfactant is selected from the group consisting of an anionic surfactant, a cationic surfactant, an amphoteric surfactant, a nonionic surfactant, and any combination thereof;
(4) the emulgator is selected from the group consisting of polyvinyl alcohol, polyoxyethylene ether, polyoxypropylene ether, and any combination thereof; and
(5) the acid scavenger is selected from the group consisting of zinc oxide, lead oxide, magnesium oxide, calcium carbonate, sodium carbonate, sodium bicarbonate, and any combination thereof.

In some embodiments, the adhesive film material includes, by mass fraction, 89.3% to 99.15% of the material of the adhesive film layer, 0.5% to 5.5% of the nanospheres, 0.1% to 2% of an initiator, 0.05% to 1% of a crosslinking agent, 0.1% to 1.8% of a silane coupling agent and 0.1% to 0.7% of an inhibitor.

In some embodiments, the method satisfies with at least one of the following conditions:
(1) the initiator is a peroxide initiator;
(2) the crosslinking agent is selected from the group consisting of triallyl cyanurate, triallyl isocyanurate, and any combination thereof; and
(3) the silane coupling agent is selected from the group consisting of γ-aminopropyl triethoxysilane (KH550), γ-(2, 3-epoxypropoxy)propyltrimethoxysilane (KH560), γ-(methacryloxy)propyltrimethoxysilane (KH570), tetraethoxysilane, and any combination thereof.

In some embodiments, the inhibitor is selected from the group consisting of an antioxidant, a UV absorber, a light stabilizer, and any combination thereof.

In some embodiments, the inhibitor is selected from the group consisting of penaerythritol-terakis-3-(3, 5-di-tert-butyl-4-hydroxyphenyl)propionate (1010), β-(3, 5-di-tert-butyl-4-hydroxyphenyl)propionic acid n-octadecanol (1076), 2-(2'-hydroxy-5'-methylphenyl)benzotriazole, ethyl salicylate, N-(2-ethoxyphenyl)-N'-(4-ethylphenyl)-ethanediamide, and any combination thereof.

In an embodiment of the present application, a photovoltaic module is further provided.

A photovoltaic module includes the composite adhesive film above or the composite adhesive film prepared by the method above.

The composite adhesive film can adjust a content of acetic acid in the photovoltaic module in time based on the acid stimulation-release principle of pH acid responsiveness, so that the photovoltaic module can be protected from acetic acid for a long time, and a component efficiency and a component reliability of the photovoltaic module can be improved. Specifically, the composite adhesive film in the present application includes an adhesive film layer and nanospheres. Each of the nanospheres includes a polymer shell and an acid scavenger encapsulated within the polymer shell. When the composite adhesive film is used for encapsulating the photovoltaic module, the polymer shell will gradually decompose to from a plurality of pore channels under conditions that the pH value is smaller than 7, thereby releasing the acid scavenger in the polymer shell via the pore channels. The smaller the pH value is, the faster the acid scavenger is released. The acid scavenger can remove acid inside the photovoltaic module. At a temperature of a lamination process of the photovoltaic module, the nanospheres are stable, and the material of the polymer shell will not be blended together with the adhesive film. Moreover, under conditions that no acetic acid is generated, the nanospheres can be stored in the adhesive film layer for a long time.

In view of above, compared to the composite adhesive film in related art, the composite adhesive film in the present application has following advantages.
(1) In the present application, the composite adhesive film including EVA component can spontaneously remove acid, so that the composite adhesive film has a long-term resistance to acidic materials, thereby reducing influence of the acetic acid on power of the photovoltaic module and reliability of the photovoltaic module.
(2) In the composite adhesive film of present application, amounts of materials such EPE, POE are reduced, and the adhesive performance of the adhesive film can be ensured. Not only a risk that the encapsulating materials delaminates is lowered, but also a producing cost of the photovoltaic module can be controlled.
(3) The photovoltaic module encapsulated with the adhesive film of the present application can work in severe environments such as a high temperature environment, a high humidity environment or a high-UV environment, and the photovoltaic module has a high reliability.
(4) In the present application, the composite adhesive film and the photovoltaic module are environmentally friendly, does not pollute the environment, and has a low cost, and thus the composite adhesive film and the photovoltaic module have many competitive advantages.

### BRIEF DESCRIPTION OF THE DRAWINGS

In order to more clearly illustrate the technical solutions in the embodiments of the present application, the accompanying drawings to be used in the description of the embodiments will be briefly described below. It will be apparent that the accompanying drawings in the following description are only some of the embodiments of the present application, and that other accompanying drawings may be obtained from these drawings without creative labor for those skilled in the art.

For a more complete understanding of the present application and its beneficial effects, the following description will be given in conjunction with the accompanying drawings. Among other things, the same accompanying callouts in the following description denote the same parts.
FIG. 1 is a structural schematic diagram of the composite adhesive film in embodiments of the present application.
FIG. 2 is an acid scavenger releasing tendency chart of the nanospheres under conditions having different pH values in first embodiment of the present application, in which an abscissa represents time (h), and a vertical coordinate represents a cumulative concentration.
FIG. 3 is a structure schematic diagram of the photovoltaic module in second embodiment of the present application.

In the figures, 10 represents a photovoltaic module; 100 represents a front panel; 200 represents a front adhesive film; 300 represents a cell main body; 400 represents a back adhesive film; 500 represents a back panel; 600 represents a composite adhesive film; 20 represents an adhesive film layer; and 30 represents a nanosphere.

### DETAILED DESCRIPTION

In order to make the above objects, features and advantages of the present application more obvious and understandable, the following description of specific embodiments of the present application is given in detail in conjunction with the accompanying drawings. Many specific details are set forth in the following description to facilitate a full understanding of the present application. However, the present application is capable of being implemented in many other ways different from those described herein, and those skilled in the art may make similar improvements without violating the connotations of the present application, and thus the present application is not limited by the specific embodiments disclosed below.

In the present application, the terms "disposed", "connected", "concentrated", "fixed" and the like are to be understood broadly unless otherwise expressly specified and limited. For example, it may be a fixed connection, a detachable connection, or a one-piece connection; it may be a mechanical connection or an electrical connection; it may be a direct connection or an indirect connection through an intermediary medium; it may be a connectivity within the two elements or an interaction between the two elements, unless otherwise expressly limited. For those of ordinary skill in the art, the specific meanings of the above terms in the present application may be understood on a case-by-case basis.

In the description of the present application, a number means more than one; a plurality means more than two; greater than, less than, more than, etc. are understood to exclude the present number; and above, below, within, etc. are understood to include the present number. If there is a description to the first, the second is only used for the purpose of distinguishing the technical features, and is not to be understood as indicating or implying relative importance or implicitly specifying the number of indicated technical features or implicitly specifying the sequential relationship of the indicated technical features.

In the present application, the sum of the parts of each component in the composition may be 100 wt. parts, if not indicated to the contrary. If not otherwise indicated, the basis for the percentages of the present application, including weight percentages, is the total weight of the composition, and, in addition, "%" herein denotes a mass percentage.

Unless otherwise defined, all technical and scientific terms used herein have the same meaning as commonly understood by those skilled in the art of the present application. Terms used herein in the specification of the present application are used only for the purpose of describing specific embodiments and are not intended to limit the present application. The term "and/or" as used herein includes any and all combinations of one or more of the relevant listed items.

In the present embodiment, a composite adhesive film 600 is provided, so as to solve the problem that a component power of the photovoltaic module and is reduced and a component reliability of the photovoltaic module is affected in the related art. In related art, when the photovoltaic module works in the outdoor environment for a long time, the adhesive film decompose and generates acetic acid under conditions of strong ultraviolet (UV), high temperature (T) and high humidity (H), resulting in corrosion of grid lines of the cell, and causing problem of reducing the component power of the photovoltaic module and affecting the component reliability of the photovoltaic module. The composite adhesive film 600 will be further described in conjunction with the figures hereinafter.

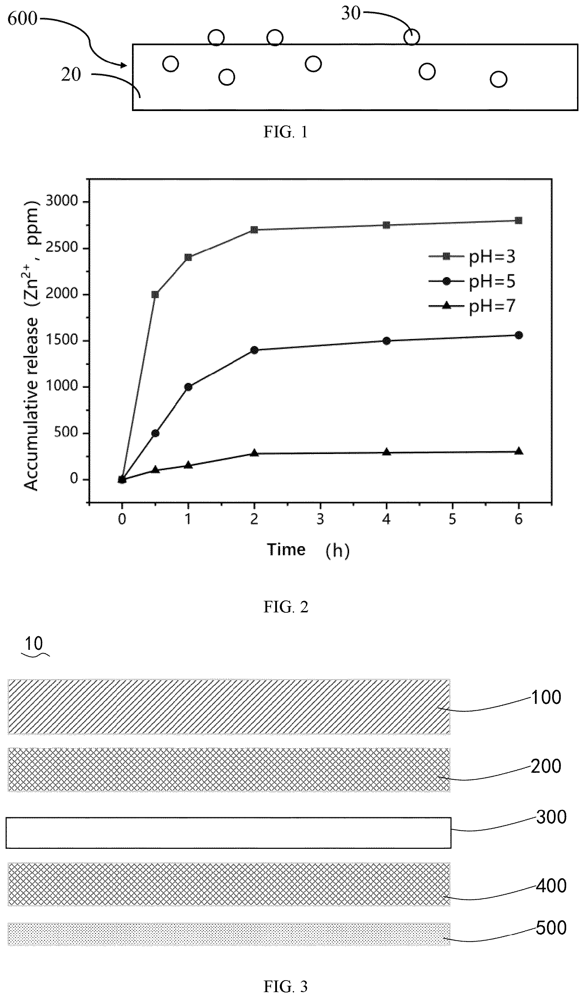

In the composite adhesive film 600 of the present embodiment, FIG. 1 is a structural schematic diagram of the composite adhesive film 600 in embodiments of the present application. The composite adhesive film 600 in the present application can be configured for production of the photovoltaic module 10, and the composite adhesive film 600 can be used for encapsulating many kinds of photovoltaic modules.

In order to describe the adhesive composite more clearly, the composite adhesive film 600 will be described in conjunction with the figures hereinafter. Referring to FIG. 1, FIG. 1 is a structural schematic diagram of the composite adhesive film 600 in embodiments of the present application.

A composite adhesive film 600 is provided. The composite adhesive film 600 includes an adhesive film layer 20 and nanospheres 30. The nanospheres 30 are disposed in the adhesive film layer 20. Each of the nanospheres 30 includes a polymer shell pH acid responsiveness and an acid scavenger encapsulated within the polymer shell. In the present application, since the polymer shell is pH acid responsive, the polymer shell will gradually decompose to from a plurality of pore channels under conditions that the pH value is smaller than 7, thereby releasing the acid scavenger in the polymer shell. The smaller the pH value is, the faster the polymer shell decomposes and the faster the acid scavenger is released. The acid scavenger can remove acid inside the photovoltaic module.

It should be noted that the nanospheres 30 may be disposed inside the adhesive film layer 20; the nanospheres 30 may be disposed on a surface of the adhesive film layer 20; optionally, the nanospheres 30 may be disposed both inside the adhesive film layer 20 and on the surface of the adhesive film layer 20 at the same time.

The composite adhesive film 600 can adjust a content of acetic acid in the photovoltaic module 10 in time based on a stimulation-release principle of pH acid responsiveness, so that the photovoltaic module 10 can be protected from acetic acid for a long time, and a component efficiency and a component reliability of the photovoltaic module 10 can be improved. Specifically, the composite adhesive film 600 in the present application includes an adhesive film layer 20 and nanospheres 30. Each of the nanospheres 30 includes a polymer shell and an acid scavenger encapsulated within the polymer shell. When the composite adhesive film 600 is used for encapsulating the photovoltaic module 10, the polymer shell will gradually decompose to from a plurality of pore channels under conditions that the pH value is smaller than 7, thereby releasing the acid scavenger in the polymer shell via the pore channels. The smaller the pH value is, the faster the acid scavenger is released. The acid scavenger can remove acid inside the photovoltaic module 10. At a temperature of a lamination process of the photovoltaic module 10, the nanospheres 30 are stable, and the material of the polymer shell will not be blended together with the adhesive film. Moreover, under conditions that no acetic acid is generated, the nanospheres 30 can be stored in the adhesive film layer 20 for a long time.

In some embodiments, the adhesive film layer 20 may include an EVA adhesive film or an EPE adhesive film. In some embodiments, the material of the adhesive film layer 20 is EVA.

In some embodiments, a particle size of the nanospheres 30 can be in a range of 50nm to 1000nm. The particle size of the nanospheres 30 should not be unduly great or unduly small. When the particle size of the nanospheres 30 is unduly small, the acid scavenger encapsulated within the polymer shell is too little, and it is difficult to produce the nanospheres 30. When the particle size of the nanospheres 30 is unduly grate, a light transmittance of the adhesive film layer 20 and an adhesive performance of the adhesive film layer 20 may be greatly affected.

In some embodiments, a mass ratio of the adhesive film layer 20 to the nanospheres 30 may be in a range of 20:1 to 150:1.

In some embodiments, a mass ratio of the polymer shell to the acid scavenger may be in a range of 1:2 to 2:1.

In some embodiments, a material of the polymer shell may be selected from the group consisting of polyacrylic acid polymers, polyacid polymers, polyalkali polymers, and any combination thereof.

In some embodiments, the acid scavenger may be selected from the group consisting of zinc oxide, lead oxide, magnesium oxide, calcium carbonate, sodium carbonate, sodium bicarbonate, and any combination thereof.

In an embodiment of the present application, a method for preparing the composite adhesive film 600 is further provided.

In the present application, the individual reaction steps can be performed in the order of the text or out of the order of the text, unless otherwise noted. For example, other steps may be included between individual reaction steps, and the order may be appropriately switched between reaction steps. This is ascertainable by the skilled person based on conventional knowledge and experience. Preferably, the reaction methods herein are performed sequentially.

A method for preparing the composite adhesive film 600 includes following steps:
mixing the nanospheres 30 and a material of the adhesive film layer 20 uniformly to obtain an adhesive film material,
extruding and casting the adhesive film material via a die to form obtain the adhesive film layer 20 and the nanospheres 30 distributed on the adhesive film layer 20,
obtaining the composite adhesive film 600 by the adhesive film layer 20 together with the nanospheres 30. It should be noted that the nanospheres 30 distributed on the adhesive film layer 20 indicates that the nanospheres 30 may be inside the adhesive film layer 20; the nanospheres 30 may be on a surface of the adhesive film layer 20; optionally, the nanospheres 30 may be both inside the adhesive film layer 20 and on the surface of the adhesive film layer 20 at the same time.

In some embodiments, the method for preparing the nanospheres 30 may include following steps:
step S1, dissolving the material of the polymer shell, a surfactant, an emulgator and the acid scavenger in a solvent to form an evenly-dissolved emulsion, wherein the emulsion includes, by mass fraction, 10% to 30% of the material of the polymer shell, 30% to 40% of the solvent, 1% to 5% of the surfactant, 3% to 10% of the emulgator and 10% to 30% of the acid scavenger;
step S2, forming the emulsion into microsphere particles; and
step S3, sieving the microsphere particles and collecting the nanospheres 30.

In some embodiments, in the step of preparing the emulsion into microsphere particles, the method may include the step: preparing the emulsion into the microsphere particles by a spray drying process.

In some embodiments, in the step of sieving the microsphere particles and collecting the nanospheres 30, the method may include the step: collecting the nanospheres 30 by means of dialysis bag sieving.

In some embodiments, a temperature of the step of dissolving the material of the polymer shell, a surfactant, an emulgator and the acid scavenger in a solvent may be in a range of 18 °C to 35 °C.

In some embodiments, the material of the polymer shell may include a main shell component and a shell adjuvant; the main shell component may be selected from the group consisting of polyacrylic acid polymers, polyacid polymers, polyalkali polymers, and any combination thereof, the shell adjuvant may be selected from the group consisting of calcium stearate, magnesium stearate, zinc stearate, and any combination thereof, wherein a mass ratio of the main shell component to the shell adjuvant may be in a range of 1:4 to 4:1.

For example, the main shell component may be selected from the group consisting of butyl methacrylate-dimethylaminoethyl methacrylate-methyl methacrylate copolymer (Eudragit E100, EPO, wherein the mass ratio of butyl methacrylate, dimethylaminoethyl methacrylate and methyl methacrylate is 1:2:1), ethyl cellulose (EC), polyacrylic acid resin IV (PAR), polyglutamic acid cross-linked polyethylene glycol, polylactic acid-hydroxyacetic acid cross-linked polyethylene glycol, Polylactic acid, chitosan, pectin, or any combination thereof.

In some embodiments, the main shell component may be EPO, the shell adjuvant may be calcium stearate, and a mass ratio of EPO to calcium stearate may be 1:1.

In some embodiments, the solvent may be an incombustible solvent having a low boiling point.

In some embodiments, the solvent may be selected from the group consisting of dichloromethane, ethanol, ether, acetone, methanol, ethyl acetate, and any combination thereof.

In some embodiments, the surfactant may be selected from the group consisting of an anionic surfactant, a cationic surfactant, an amphoteric surfactant, a nonionic surfactant, and any combination thereof.

In some embodiments, the surfactant may be selected from the group consisting of sodium dodecyl sulphate, cetyltrimethylammonium bromide, alkyl dimethyl betaine, polyethylene glycol, and any combination thereof.

In some embodiments, the emulgator may be selected from the group consisting of polyvinyl alcohol, polyoxyethylene ether, polyoxypropylene ether, and any combination thereof.

In some embodiments, the acid scavenger may be selected from the group consisting of zinc oxide, lead oxide, magnesium oxide, calcium carbonate, sodium carbonate, sodium bicarbonate, and any combination thereof.

In some embodiments, the adhesive film material may include, by mass fraction, 89.3% to 99.15% of the material of the adhesive film layer, 0.5% to 5.5% of the nanospheres 30, 0.1% to 2% of an initiator, 0.05% to 1% of a crosslinking agent, 0.1% to 1.8% of a silane coupling agent and 0.1% to 0.7% of an inhibitor.

In some embodiments, the initiator may be a peroxide initiator.

In some embodiments, the initiator may be selected from the group consisting of diisopropylbenzene peroxide, tert-butyl hydroperoxide and dibenzoyl peroxide, and any combination thereof.

In some embodiments, the crosslinking agent may be selected from the group consisting of triallyl cyanurate (TAC), triallyl isocyanurate (TAIC), and any combination thereof.

In some embodiments, the silane coupling agent may be selected from the group consisting of γ-aminopropyl triethoxysilane (KH550), γ-(2, 3-epoxypropoxy)propyltrimethoxysilane (KH560), γ-(methacryloxy)propyltrimethoxysilane (KH570), tetraethoxysilane, and any combination thereof.

In some embodiments, the inhibitor may be selected from the group consisting of an antioxidant, a UV absorber, a light stabilizer, and any combination thereof.

In some embodiments, the inhibitor may be selected from the group consisting of penaerythritol-terakis-3-(3, 5-di-tert-butyl-4-hydroxyphenyl)propionate (1010), β-(3, 5-di-tert-butyl-4-hydroxyphenyl)propionic acid n-octadecanol (1076), 2-(2'-hydroxy-5'-methylphenyl)benzotriazole, ethyl salicylate, N-(2-ethoxyphenyl)-N'-(4-ethylphenyl)-ethanediamide, and any combination thereof.

It should be noted that the present application relates to a numerical range (i.e., a range of values). If not specifically stated, the optional values within that numerical range is considered to be continuous and includes the two numerical endpoints (i.e., a minimum value and a maximum value) of the numerical range, as well as each of the numerical values between those two numerical endpoints. Unless otherwise noted, when the numerical range refers only to integers within that numerical range, the numerical range includes the two endpoint integers of that numerical range and each integer between the two endpoints, and is equivalent to directly enumerating each integer. When more than one numerical range is provided to describe a characteristic or feature, these numerical ranges may be combined. In other words, unless otherwise indicated, the numerical ranges disclosed in the present application are to be understood as including any and all sub-ranges subsumed therein. The "value" in the numerical range may be any quantitative value, such as a number, a percentage, a ratio, and the like. "Numerical range" are allowed to broadly include quantitative intervals such as percentage intervals, proportional intervals, ratio intervals, and the like.

In an embodiment of the present application, a photovoltaic module 10 is further provided.

A photovoltaic module 10 includes the composite adhesive film 600 above or the composite adhesive film 600 prepared by the method above.

In some embodiments, the photovoltaic module 10 may include a front panel 100, a front adhesive film 200, a cell main body 300, a back adhesive film 400 and a back panel 500. The front panel 100, the front adhesive film 200, the cell main body 300, the back adhesive film 400 and the back panel 500 are successively stacked with each other. At least one of the front adhesive film 200 and the back adhesive film 400 include the composite adhesive film 600 described above.

In some embodiments, the front panel 100 and the back panel 500 may be a photovoltaic glass panel.

In some embodiments of the present application, a method for assessing a pH-responding releasing performance of the nanospheres 30.

The method for assessing the pH-responding releasing performance of the nanospheres 30 includes following steps:
(1) preparing acetic acid solutions having different pH gradients (the pH values of the acetic acid solutions may be 3, 5, or 7);
(2) placing the nanospheres 30 into dialysis bags, and immersing the dialysis bags into acetic acid solutions having different pH values; and
(3) assessing the releasing performance of the nanospheres 30 by testing a Zn²⁺ content in the acetic acid solutions.

### First embodiment

A composite adhesive film 600 was provided in the present embodiment.

A method for preparing the composite adhesive film 600 included following steps.

Step S1, preparation of the nanospheres 30. A method for preparing the nanospheres 30 included following steps.

Step S11, a polymer shell, a surfactant (sodium dodecyl sulphate), an emulgator (polyvinyl alcohol) and an acid scavenger (zinc oxide) were dissolved in a solvent (dichloromethane) to form an evenly-dissolved emulsion at 25 °C. The emulsion included, by mass fraction, 30% of the material of the polymer shell, 30% of the solvent, 5% of the surfactant, 10% of the emulgator and 25% of the acid scavenger. The material of the polymer shell included a main shell component and a shell adjuvant. The main shell component was EPO, and the shell adjuvant was calcium stearate. A mass ratio of EPO to calcium stearate was 1:1.

Step S12, the emulsion was formed into microsphere particles by method of spray drying.

Step S13, the microsphere particles were sieved with an analysis bag, so that microsphere particles having suitable particle sizes were selected and defined as the nanospheres 30.

Step S14, the pH-responding releasing performance of the nanospheres 30 was assessed by the method for assessing the pH-responding releasing performance of the nanospheres 30 described above, and the results were shown in FIG. 2. With decreasing of the pH values, increasing of the content of Zn²⁺ in the solution became faster, which indicated that the nanospheres 30 release the acid scavenger faster in a solution has higher acetic acid content, and the nanospheres 30 have good pH-responding releasing performance of the nanospheres 30.

Step S2, the nanospheres 30 obtained in step S1, the material of the adhesive film layer (EVA), the initiator (diisopropylbenzene peroxide), the crosslinking agent (triallyl cyanurate TAC), the silane coupling agent (γ-aminopropyl triethoxysilane, KH550) and the inhibitor (inhibitor penaerythritol-terakis-3-(3, 5-di-tert-butyl-4-hydroxyphenyl)propionate, 1010) were mixed evenly to obtain the adhesive film material. The adhesive film material included, by mass fraction, 94.65% of the material of the adhesive film layer, 3% of the nanospheres 30, 0.5% of the initiator, 1% of the crosslinking agent, 0.5% of the silane coupling agent and 0.35% of the inhibitor.

Step S3, the adhesive film material were extruded and casted via a die to form the adhesive film layer and the nanospheres 30 distributed on the adhesive film layer, and composite adhesive film 600 was obtained by the adhesive film layer 20 together with the nanospheres 30.

### Second embodiment

A photovoltaic module 10 was provided in the present embodiment.

Referring to FIG. 3, the photovoltaic module 10 included a front panel 100, a front adhesive film 200, a cell main body 300, a back adhesive film 400 and a back panel 500. The front panel 100, the front adhesive film 200, the cell main body 300, the back adhesive film 400 and the back panel 500 were successively stacked with each other. The front adhesive film 200 was the composite adhesive film 600 obtained in the first embodiment, and the back adhesive film 400 was an EVA adhesive film. Both the front panel 100 and the back panel 500 were glass panels. The cell main body 300 was a n-TOpCon cell.

### First comparative embodiment

A composite adhesive film was provided in the present comparative embodiment.

The method for preparing the composite adhesive film in the present embodiment was almost the same with the method in the first embodiment. The differences between the present embodiment and the first embodiment were: the adhesive film material included, by mass fraction, 97.65% of the material of the adhesive film layer, 0% of the nanospheres 30, 0.5% of the initiator, 1% of the crosslinking agent, 0.5% of the silane coupling agent and 0.35% of the inhibitor.

### Second comparative embodiment

A composite adhesive film was provided in the present comparative embodiment.

The method for preparing the composite adhesive film in the present embodiment was almost the same with the method in the first embodiment. The differences between the present embodiment and the first embodiment were: the adhesive film material included, by mass fraction, 97.55% of the material of the adhesive film layer, 0.1% of the nanospheres 30, 0.5% of the initiator, 1% of the crosslinking agent, 0.5% of the silane coupling agent and 0.35% of the inhibitor.

### Third comparative embodiment

A composite adhesive film was provided in the present comparative embodiment.

The method for preparing the composite adhesive film in the present embodiment was almost the same with the method in the first embodiment. The differences between the present embodiment and the first embodiment were: the adhesive film material included, by mass fraction, 90.15% of the material of the adhesive film layer, 7.5% of the nanospheres 30, 0.5% of the initiator, 1% of the crosslinking agent, 0.5% of the silane coupling agent and 0.35% of the inhibitor.

### Fourth comparative embodiment

A photovoltaic module 10 was provided in the present comparative embodiment.

The photovoltaic module 10 in the present embodiment was almost the same with the photovoltaic module 10 in the second embodiment. The differences between the present embodiment and the first embodiment were: the front adhesive film 200 in the photovoltaic module 10 of the present comparative embodiment was the composite adhesive film in the first comparative embodiment.

### Fifth comparative embodiment

A photovoltaic module 10 was provided in the present comparative embodiment.

The photovoltaic module 10 in the present embodiment was almost the same with the photovoltaic module 10 in the second embodiment. The differences between the present embodiment and the first embodiment were: the front adhesive film 200 in the photovoltaic module 10 of the present comparative embodiment was the composite adhesive film in the second comparative embodiment.

### Sixth comparative embodiment

A photovoltaic module 10 was provided in the present comparative embodiment.

The photovoltaic module 10 in the present embodiment was almost the same with the photovoltaic module 10 in the second embodiment. The differences between the present embodiment and the first embodiment were: the front adhesive film 200 in the photovoltaic module 10 of the present comparative embodiment was the composite adhesive film in the third comparative embodiment.

Light transmittances of the composite adhesive films in the first embodiment, and the first comparative embodiment to the third comparative embodiment were tested, and shown in Table 1. Referring to FIG. 2, the light transmittances of the composite adhesive films in the first embodiment, and the first comparative embodiment to the second comparative embodiment were almost the same. The first embodiment was compared to the first and second comparative embodiments, it could be concluded that 3% of the nanospheres 30 in the first embodiment did not influence the light transmittance of the composite adhesive film. The first embodiment was compared to the third comparative embodiment, it could be concluded that 7.5% of the nanospheres 30 in the third comparative embodiment will affect the light transmittance of the composite adhesive film. Therefore, the content of the nanospheres 30 in the composite adhesive film should not be too great.

The photovoltaic module 10 of the second embodiment and the photovoltaic module 10 of the fourth to sixth comparative embodiments were subjected to power test, UV120 reliability test, and DH2000 reliability test, and the results were shown in Table 2.

**Table 1**

| No. | | | | | | | |
|---|---|---|---|---|---|---|---|
| | The adhesive film material | nanosphere s | Initiator | Crosslinking agent | Silane coupling agent | Inhibitor | Light transmittance (380nm to 1100nm) |
| First embodiment | 94.65wt% of EVA | 3 wt% | 0.5wt% of diisopropylbenze ne peroxide | 1wt% of TAC | 0.5wt% of KH550 | 0.35wt% of 1010 | 91.65% |
| First comparative embodiment | 97.65wt% of EVA | 0 | 0.5wt% of diisopropylbenze ne peroxide | 1wt% of TAC | 0.5wt% of KH550 | 0.35wt% of 1010 | 91.80% |
| Second comparative embodiment | 97.55wt% of EVA | 0.1wt% | 0.5wt% of diisopropylbenze ne peroxide | 1wt% of TAC | 0.5wt% of KH550 | 0.35wt% of 1010 | 91.75% |
| Third comparative embodiment | 90.15wt% of EVA | 7.5wt% | 0.5wt% of diisopropylbenze ne peroxide | 1wt% of TAC | 0.5wt% of KH550 | 0.35wt% of 1010 | 88.45% |

**Table 2**

| No. | Cell main body 300 | Encapsulating materials | | | | Performance | Reliability | | Whether the front adhesive film 200 delaminates or not |
|---|---|---|---|---|---|---|---|---|---|
| | | front panel 100 | front adhesive film 200 | back adhesive film 400 | back panel 500 | initial power of the photovoltaic module 10 | UV120 | DH2000 | |
| Second embodiment | n-TOpCon cell | photovoltaic glass panel | First embodiment | EVA | photovoltaic glass panel | 574.4 | 2.44% | 3.23% | No |
| Fourth comparative embodiment | n-TOpCon cell | photovoltaic glass panel | First comparative embodiment | EVA | photovoltaic glass panel | 575.3 | 10.21% | 9.67% | No |
| Fifth comparative embodiment | n-TOpCon cell | photovoltaic glass panel | Second comparative embodiment | EVA | photovoltaic glass panel | 575.2 | 6.79% | 5.85% | No |
| Sixth comparative embodiment | n-TOpCon cell | photovoltaic glass panel | Third comparative embodiment | EVA | photovoltaic glass panel | 556.1 | 12.60% | 15.33% | Yes |

Referring to Table 2, the reliability of the photovoltaic module 10 is affected by UV and DH. The second embodiment is compared to the fourth and fifth comparative embodiment, it could be concluded that decrement of the UV120 and decrement of the DH200 significantly reduced when a proper amount (0.5wt% to 5.5wt%, by mass fraction) of the nanospheres were added in the front adhesive film 200. In addition, the second embodiment is compared to the sixth comparative embodiment, it could be concluded that the front adhesive film 200 delaminated in the sixth comparative embodiment. It could be concluded that on account of unduly great amount of the nanospheres in the front adhesive film 200, the adhesive performance of the EVA adhesive film body was affected. Thus, it could be concluded that the amount of the nanospheres in the composite adhesive film was in a range of 0.5% to 5.5%.

In view of the above, the composite adhesive film has following advantages.
(1) In the present application, the composite adhesive film including EVA component can spontaneously remove acid, so that the composite adhesive film has a long-term resistance to acidic materials, thereby reducing influence of the acetic acid on power of the photovoltaic module 10 and reliability of the photovoltaic module 10.
(2) In the composite adhesive film of present application, amounts of materials such EPE, POE are reduced, and the adhesive performance of the adhesive film can be ensured. Not only a risk that the encapsulating materials delaminates is lowered, but also a producing cost of the photovoltaic module 10 can be controlled.
(3) The photovoltaic module 10 encapsulated with the adhesive film of the present application can work in severe environments such as a high temperature environment, a high humidity environment or a high-UV environment, and the photovoltaic module 10 has a high reliability.
(4) In the present application, the composite adhesive film and the photovoltaic module 10 are environmentally friendly, does not pollute the environment, and has a low cost, and thus the composite adhesive film and the photovoltaic module 10 have many competitive advantages.

In the above embodiments, the description of each embodiment has its own focus, and parts of an embodiment that are not described in detail can be found in the relevant descriptions of other embodiments.

The technical features of the above-mentioned embodiments can be combined arbitrarily. In order to make the description concise, not all possible combinations of the technical features are described in the embodiments. However, as long as there is no contradiction in the combination of these technical features, the combinations should be considered as in the scope of the present application.

The above-described embodiments are only several implementations of the application, and the descriptions are relatively specific and detailed, but they should not be construed as limiting the scope of the application. It should be understood by the skilled in the art that various modifications and improvements can be made without departing from the concept of the application, and all fall within the protection scope of the application. Thus, the patent protection of the application shall be defined by the appended claims.

## Claims

1. A composite adhesive film, **characterized by** comprising an adhesive film layer and nanospheres,
wherein the nanospheres are distributed on the adhesive film layer, each of the nanospheres comprises a polymer shell with pH acid responsiveness and an acid scavenger encapsulated within the polymer shell.

2. The composite adhesive film of claim 1, wherein the adhesive film layer comprises an EVA adhesive film or an EPE adhesive film.

3. The composite adhesive film of claim 1, wherein a particle size of the nanospheres is in a range of 50 nm to 1000 nm.

4. The composite adhesive film of claim 1, wherein a mass ratio of the adhesive film layer to the nanospheres is in a range of 20:1 to 150:1.

5. The composite adhesive film of claim 1, wherein a mass ratio of the polymer shell to the acid scavenger is in a range of 1:2 to 2:1.

6. The composite adhesive film of any one of claims 1 to 5, wherein a material of the polymer shell is selected from the group consisting of polyacrylic acid polymers, polyacid polymers, polyalkali polymers, and any combination thereof.

7. The composite adhesive film of any one of claims 1 to 5, wherein the acid scavenger is selected from the group consisting of zinc oxide, lead oxide, magnesium oxide, calcium carbonate, sodium carbonate, sodium bicarbonate, and any combination thereof.

8. A method for preparing the composite adhesive film of any one of claims 1 to 7, **characterized by** comprising following steps:
mixing the nanospheres and a material of the adhesive film layer uniformly to obtain an adhesive film material,
extruding and casting the adhesive film material via a die to form the adhesive film layer and the nanospheres distributed on the adhesive film layer, and obtaining the composite adhesive film by the adhesive film layer together with the nanospheres.

9. The method of claim 8, wherein forming the nanospheres further comprises following steps:
dissolving a material of the polymer shell, a surfactant, an emulgator and the acid scavenger in a solvent to form an evenly-dissolved emulsion, wherein the emulsion comprises, by mass fraction, 10% to 30% of the material of the polymer shell, 30% to 40% of the solvent, 1% to 5% of the surfactant, 3% to 10% of the emulgator and 10% to 30% of the acid scavenger;
forming the emulsion into microsphere particles; and
sieving the microsphere particles and collecting the nanospheres.

10. The method of claim 9, wherein the method satisfies with at least one of the following conditions:
(1) in the step of preparing the emulsion into microsphere particles, further comprising forming the emulsion into the microsphere particles by a spray drying method;
(2) in the step of sieving the microsphere particles and collecting the nanospheres, further comprising: collecting the nanospheres by means of dialysis bag sieving and collecting the nanospheres; and
(3) a temperature of the step of dissolving the material of the polymer shell, a surfactant, an emulgator and the acid scavenger in a solvent is in a range of 18 °C to 35 °C.

11. The method of claim 9, wherein the method satisfies with at least one of the following conditions:
(1) the material of the polymer shell comprises a main shell component and a shell adjuvant; wherein the main shell component is selected from the group consisting of polyacrylic acid polymers, polyacid polymers, polyalkali polymers, and any combination thereof, the shell adjuvant is selected from the group consisting of calcium stearate, magnesium stearate, zinc stearate, and any combination thereof, a mass ratio of the main shell component to the shell adjuvant is in a range of 1:4 to 4: 1;
(2) the solvent is an incombustible solvent having a low boiling point;
(3) the surfactant is selected from the group consisting of an anionic surfactant, a cationic surfactant, an amphoteric surfactant, a nonionic surfactant, and any combination thereof;
(4) the emulgator is selected from the group consisting of polyvinyl alcohol, polyoxyethylene ether, polyoxypropylene ether, and any combination thereof; and
(5) the acid scavenger is selected from the group consisting of zinc oxide, lead oxide, magnesium oxide, calcium carbonate, sodium carbonate, sodium bicarbonate, and any combination thereof.

12. The method of any one of claims 8 to 11, wherein the adhesive film material comprises, by mass fraction, 89.3% to 99.15% of the material of the adhesive film layer, 0.5% to 5.5% of the nanospheres, 0.1% to 2% of an initiator, 0.05% to 1% of a crosslinking agent, 0.1% to 1.8% of a silane coupling agent and 0.1% to 0.7% of an inhibitor.

13. The method of claim 12, wherein the method satisfies with at least one of the following conditions:
(1) the initiator is a peroxide initiator;
(2) the crosslinking agent is selected from the group consisting of triallyl cyanurate, triallyl isocyanurate, and any combination thereof; and
(3) the silane coupling agent is selected from the group consisting of γ-aminopropyl triethoxysilane, γ-(2, 3-epoxypropoxy)propyltrimethoxysilane, γ-(methacryloxy)propyltrimethoxysilane, tetraethoxysilane, and any combination thereof.

14. The method of claim 12, wherein the inhibitor is selected from the group consisting of an antioxidant, a UV absorber, a light stabilizer, and any combination thereof; optionally wherein the inhibitor is selected from the group consisting of penaerythritol-terakis-3-(3, 5-di-tert-butyl-4-hydroxyphenyl)propionate, β-(3, 5-di-tert-butyl-4-hydroxyphenyl)propionic acid n-octadecanol, 2-(2'-hydroxy-5'-methylphenyl)benzotriazole, ethyl salicylate, N-(2-ethoxyphenyl)-N'-(4-ethylphenyl)-ethanediamide, and any combination thereof.

15. A photovoltaic module, **characterized by** comprising the composite adhesive film of any one of claims 1 to 7, or the composite adhesive film prepared by the method of any one of claims 8 to 14.
